# FASCICULE DE BREVET EUROPEEN

(11) **EP 2 750 180 B1**
(45) Date de publication et mention de la délivrance du brevet: **20.02.2019**
(21) Numéro de dépôt: 13198071.6
(22) Date de dépôt: 18.12.2013
(51) Int. Cl.: H01L 21/84, H01L 27/02, H01L 27/118, H01L 27/12, H03K 19/177, H01L 29/786

(54) **Circuit intégré comprenant une cellule d'arbre d'horloge**
Integrierter Schaltkreis, der eine Taktbaumzelle umfasst
Integrated circuit including a clock tree cell

(30) Priorité: 26.12.2012 FR 1262812
(43) Date de publication de la demande: 02.07.2014
(73) Titulaire: Commissariat à l'Énergie Atomique et aux Énergies Alternatives, 75015 Paris (FR); STMicroelectronics SA, 92120 Montrouge (FR); STMicroelectronics (Crolles 2) SAS, 38920 Crolles (FR)
(72) Inventeur: Thonnart, Yvain, 38100 Grenoble (FR); Giraud, Bastien, 38000 Grenoble (FR); Abouzeid, Fady, 38000 Grenoble (FR); Clerc, Sylvain, 38000 Grenoble (FR); Noel, Jean-Philippe, 38330 Montbonnot Saint Martin (FR)
(74) Mandataire: GIE Innovation Competence Group

(56) Documents cités:
- WO-A1-2012/160071
- US-A1- 2006 027 877
- JEAN-PHILIPPE NOEL ET AL: "Multi- $V_{T}$ UTBB FDSOI Device Architectures for Low-Power CMOS Circuit", IEEE TRANSACTIONS ON ELECTRON DEVICES, IEEE SERVICE CENTER, PISACATAWAY, NJ, US, vol. 58, no. 8, août 2011 (2011-08), pages 2473-2482, XP011336322, ISSN: 0018-9383, DOI: 10.1109/TED.2011.2155658
- Philippe Flatresse ET AL: "Planar fully depleted silicon technology to design competitive SOC at 28nm and beyond", , février 2012 (2012-02), XP055065624, Extrait de l'Internet: URL:http://www.soiconsortium.org/pdf/fully depletedsoi/planar_fd_silicon_technology_c ompetitive_soc_28nm.pdf [extrait le 2013-06-06]
- J-P NOEL ET AL: "UT2B-FDSOI device architecture dedicated to low power design techniques", SOLID-STATE DEVICE RESEARCH CONFERENCE (ESSDERC), 2010 PROCEEDINGS OF THE EUROPEAN, IEEE, PISCATAWAY, NJ, USA, 14 septembre 2010 (2010-09-14), pages 210-213, XP031787588, ISBN: 978-1-4244-6658-0
- VASILIS F PAVLIDIS ET AL: "Clock distribution networks for 3-D ictegrated Circuits", CUSTOM INTEGRATED CIRCUITS CONFERENCE, 2008. CICC 2008. IEEE, IEEE, PISCATAWAY, NJ, USA, 21 septembre 2008 (2008-09-21), pages 651-654, XP031361544, ISBN: 978-1-4244-2018-6

## Description

L'invention concerne un circuit intégré. L'invention concerne également un procédé d'utilisation de ce circuit intégré.

L'invention s'applique notamment au circuits intégrés réalisés sur un substrat de type silicium-sur-isolant (dit SOI, pour « Silicon On Insulator » en langue anglaise). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes, ou une même consommation pour de meilleurs performances. De tels circuits induisent également des capacités parasites plus faibles, qui permettent d'améliorer la vitesse de commutation. De plus, le phénomène de déclenchement parasite (« latchup » en langue anglaise) rencontré par les transistors métal-oxyde-semi-conducteur (MOS) en technologie « bulk » peut être évité. De tels circuits s'avèrent donc particulièrement adaptés pour des applications de type SoC (« Systems on Chip » en langue anglaise) ou MEMS (« Micro Electro-Mechanical Systems » en langue anglaise). On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM (« Static Random Access Memory » en langue anglaise) ou des portes logiques.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on abaisse la tension de seuil (« threshold voltage » en langue anglaise, et abrévié V_{T}) de certains transistors pour former des portes logiques à vitesse de basculement élevée, et on augmente la tension seuil d'autres transistors pour former des portes logiques à faible consommation. En technologie « bulk », la modulation du niveau de tension de seuil de transistors de même type est principalement effectuée en différenciant le niveau de dopage de leur canal. Cependant, en technologie semi-conducteur sur isolant à canal complètement déserté, plus connue sous l'acronyme FDSOI (pour « Fully Depleted Silicon On Insulator » en langue anglaise), le dopage du canal est quasiment nul (10¹⁵ cm⁻³). Ainsi, le niveau de dopage du canal des transistors ne peut donc pas présenter de variations importantes, ce qui empêche de différencier les tensions de seuil par ce biais. Une solution proposée dans certaines études, pour réaliser des transistors de même type à tensions de seuil distinctes, est d'intégrer différents matériaux de grille pour ces transistors. Cependant, la réalisation pratique d'un tel circuit intégré s'avère techniquement délicate et économiquement prohibitive.

Afin de disposer de tensions de seuil distinctes pour différents transistors en technologie FDSOI, il est également connu d'utiliser un plan de masse (« ground plane » ou « back-plane » en langue anglaise) électriquement polarisé disposé entre une couche d'oxyde isolante mince et le substrat de silicium. En jouant sur le type de dopage des plans de masse et sur leur polarisation électrique, il est possible d'améliorer le contrôle électrostatique de ces transistors, ce qui permet de définir différentes gammes de tensions de seuil pour ces transistors. On peut ainsi disposer de transistors à faible tension de seuil, dits LVT (pour « Low V_{T} » en langue anglaise), de transistors à haute tension de seuil, dits HVT (pour « High V_{T} » en langue anglaise), et de transistors à tension de seuil intermédiaire, dits SVT (pour « Standard V_{T} » en langue anglaise), ou RVT (pour « Regular V_{T} » en langue anglaise). Typiquement, les transistors LVT présentent une tension de seuil inférieure ou égale à 350mV, les transistors HVT supérieure ou égale à 500mV et les transistors RVT comprise entre 350mV et 500mV.

De tels transistors sont décrits, par exemple, dans la note d'application technique de P. Flatresse et al., « Planar fully depleted silicon technology to design compétitive SOC at 28nm and beyond », STMicroelectronics, 2012, disponible sur le site Internet « www.soiconsortium.org ».

De l'état de la technique est aussi connu des documents suivants :
- WO 2012/160071 A1 (CEA) ;
- Jean-Philippe Noel et al. « Multi-VT UTBB FDSOI device architectures for low-power CMOS circuit », IEEE Transactions on Electron Devices, vol. 58, p. 2473-2482, août 2011 ;
- US 2006/027877 A1 (INABA).

De façon connue, les circuits intégrés logiques synchrones nécessitent un signal d'horloge pour synchroniser le fonctionnement d'éléments logiques du circuit. Typiquement, ce signal d'horloge est distribué depuis un générateur de signal d'horloge vers des éléments du circuit, tels que des registres ou des bascules, par l'intermédiaire d'un arbre d'horloge (« clock tree » en langue anglaise). Cet arbre d'horloge est un réseau d'interconnexions électriques qui présente typiquement une structure arborescente, comportant un tronc commun, relié au générateur de signal d'horloge et se partageant en une multitude de rameaux, ou branches. Chacune de ces branches peut elle-même se partager en une pluralité de branches additionnelles.

Pour assurer un bon fonctionnement du circuit, et notamment éviter des erreurs de minutage (« setup & hold time violations » en langue anglaise), cet arbre d'horloge doit être soigneusement configuré pour limiter l'apparition de différences de temps de propagation (« clock skew » en langue anglaise) du signal d'horloge. A cet effet, l'arbre d'horloge comprend typiquement des cellules d'arbre d'horloge, qui implémentent des fonctions optimisant la distribution du signal d'horloge, telles que l'ajout de délais (« buffer » en langue anglaise). Ainsi, chaque cellule d'arbre d'horloge est reliée à une branche de l'arbre d'horloge, et reçoit de cet arbre d'horloge un signal d'horloge entrant. Cette cellule d'arbre d'horloge est également adaptée pour fournir un signal d'horloge sortant, apte à être distribué aux éléments logiques du circuit. Dans le cas où la cellule d'arbre d'horloge présente un délai, le signal d'horloge sortant est identique au signal d'horloge entrant, sauf qu'il présente un retard égal à une valeur prédéfinie. Ces délais peuvent être adaptés lors d'étapes de conception du circuit intégré, pour équilibrer les branches de l'arbre d'horloge et contrôler l'apparition de différences de temps de propagation.

Cependant, l'intégration d'une telle cellule d'arbre d'horloge au sein d'un circuit comprenant des cellules standards de technologie FDSOI de tensions de seuil différentes présente de nombreux inconvénients.

Typiquement, le circuit comprend également des cellules dites standard, contenant des transistors connectés de façon à former les éléments logiques du circuit. Dans cette description, le terme de cellule standard désigne une portion de circuit intégré correspondant à l'implémentation physique d'une cellule d'une bibliothèque d'un logiciel de conception de circuits intégrés. Les cellules standard ne sont donc pas nécessairement toutes identiques les unes aux autres. Par contre, ces cellules standard n'appartiennent pas à l'arbre d'horloge.

En technologie FDSOI 28nm, ces cellules standards sont typiquement arrangées dans le circuit sous forme de blocs. Les cellules standard appartenant à un même bloc présentent toutes une même gamme de tensions de seuil. Lorsqu'il y a plusieurs blocs implantés sur un même substrat, chaque bloc comporte son propre caisson profondément enterré au-dessus duquel sont réalisées chacune des cellules standards de ce bloc pour les isoler électriquement du substrat. Si un tel caisson profondément enterré n'existe pas, on considère que toutes les cellules standards réalisées sur le substrat appartiennent au même bloc. Chaque bloc présente une forme régulière, et contient une pluralité de cellules standard contiguës les unes aux autres. Ici, des cellules sont dites « contiguës », si elles sont uniquement séparées l'une de l'autre par une tranchée d'isolation, typiquement, profonde. Chaque bloc présente ici une forme sensiblement rectangulaire. Deux blocs distincts et, en particulier leurs caissons profondément enterrés respectifs, sont espacés entre eux par une zone de séparation en forme de bande. La largeur de cette bande est, par exemple, supérieure ou égale à quelques micromètres. De préférence, aucun transistor n'est implanté dans cette zone de séparation.

Des cellules de l'arbre d'horloge, situées aux extrémités des branches, sont électriquement reliées à des cellules standard, pour leur transmettre le signal d'horloge sortant. Ces cellules de l'arbre d'horloge situées aux extrémités des branches sont appelées feuilles de l'arbre d'horloge (« clock tree leaf » en langue anglaise).

Les cellules d'arbre d'horloge habituellement utilisées sont structurellement similaires aux cellules standards du circuit. Les cellules feuilles de l'arbre d'horloge sont intégrées préférentiellement au sein de chaque bloc, au plus près des cellules standards, notamment pour réduire la longueur des liaisons électriques reliant ces cellules feuilles aux cellules standard voisines.

Il existe donc un intérêt pour un circuit intégré comprenant des transistors de technologie FDSOI 28nm, ce circuit comprenant une cellule d'arbre d'horloge qui soit apte à être électriquement contrôlée indépendamment des cellules standard du circuit tout en minimisant la superficie requise par l'intégration de cette cellule d'arbre d'horloge au sein d'un bloc de cellules standards dont présentant une même gamme de tension de seuil.

Cependant, dans chaque bloc du circuit, la cellule d'arbre d'horloge doit être suffisamment isolée des cellules standards adjacentes pour éviter que son fonctionnement soit affecté par des polarisations électriques appliquées au plan de masse de ces cellules standards. Avec les règles de dessin actuelles pour la technologie FDSOI 28nm, une telle cellule d'arbre d'horloge est séparée des cellules standard par un espacement de plusieurs micromètres, ce qui engendre une perte d'espace pouvant atteindre 10 % de la superficie du bloc. Une telle perte d'espace limite la quantité d'éléments logiques pouvant être réalisés sur le circuit, ce qui n'est pas économiquement acceptable.

L'invention porte ainsi sur un circuit intégré conforme à la revendication 1.

Ainsi, la cellule d'arbre d'horloge peut être intégrée au sein d'un bloc de cellules standard, en ne nécessitant qu'une superficie réduite, car elle ne comporte qu'un seul caisson semi-conducteur. Ce caisson de la cellule d'arbre d'horloge est isolé électriquement des caissons des cellules standard adjacentes qui présentent un dopage de même type, en l'entourant par la bande semi-conductrice qui présente un dopage de type opposé. Cette bande est mise en contact avec ce caisson de la cellule d'arbre d'horloge, de manière à former une jonction p-n polarisée en sens inverse, ce qui assure l'isolation électrique entre ces cellules. Cette configuration spécifique permet de s'affranchir des règles de dessin qui imposaient un espacement important entre ces cellules, et permet ainsi de réduire la superficie occupée par la cellule d'arbre d'horloge.

Les modes de réalisation de l'invention peuvent comporter une ou plusieurs des caractéristiques des revendications 2 à 12.

Ces modes de réalisation présentent en outre les avantages suivants :
- le caisson profondément enterré permet d'isoler électriquement du substrat les premier et troisième caissons, ce qui limite le risque d'apparition d'un courant de fuite entre ces caissons et le substrat.
- la portion de la cellule d'arbre d'horloge, située au-dessus de la bande semi-conductrice peut être utilisée pour placer des diodes d'antenne ou des condensateurs de découplage qui, autrement, auraient été placés en d'autres positions du circuit, ce qui permet de réduire la superficie occupée par le bloc de cellules standard.

L'invention concerne également un procédé d' utilisation d'un circuit intégré conforme à la revendication 13.

L'invention sera mieux comprise à la lecture de la description qui va suivre, donnée uniquement à titre d'exemple non limitatif et faite en se référant aux dessins sur lesquels :
- la figure 1 est une illustration schématique d'une partie d'un circuit intégré comprenant un arbre d'horloge ;
- la figure 2 est une illustration schématique d'une coupe longitudinale d'un bloc du circuit intégré de la figure 1 ;
- la figure 3 est une vue schématique en coupe transversale d'une rangée du bloc de la figure 2 ;
- la figure 4 est une vue schématique en coupe transversale d'une cellule d'arbre d'horloge du bloc de la figure 2 ;
- la figure 5 est une vue schématique, en coupe transversale, des cellules des figures 3 et 4 accolées l'une à l'autre ;
- la figure 6 est une illustration schématique d'un autre mode de réalisation du bloc de la figure 2 ;
- la figure 7 est un organigramme d'un procédé d'utilisation du circuit intégré de la figure 1.

Dans ces figures, les mêmes références sont utilisées pour désigner les mêmes éléments.

Dans la suite de cette description, les caractéristiques et fonctions bien connues de l'homme du métier ne sont pas décrites en détails.

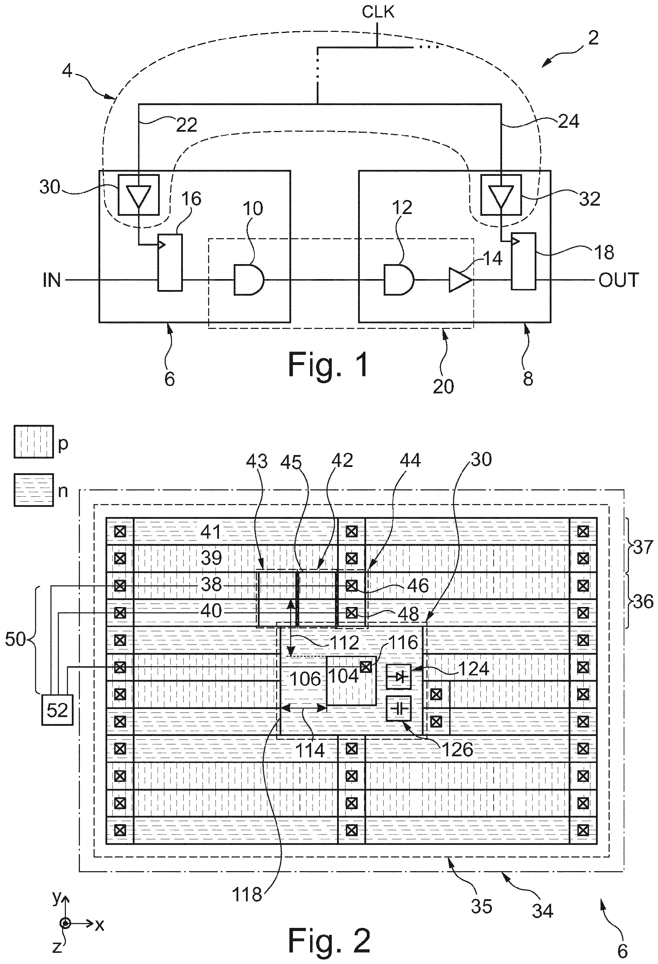

La figure 1 représente, de manière simplifiée, une partie d'un circuit intégré 2, contenant un arbre d'horloge 4. Dans cet exemple, le circuit 2 comprend des blocs 6 et 8 qui contiennent une pluralité d'éléments logiques (tels que des portes logiques) et d'éléments synchrones (tels que des bascules), formés à partir de transistors contenus dans des cellules standards disposées dans ces blocs 6 et 8. Au sein de chaque bloc 6 et 8, les transistors de ces cellules standards présentent une même gamme de tension de seuil, par exemple de niveau faible (LVT), standard (RVT) ou élevé (HVT). Par exemple, les transistors du bloc 6 présentent une gamme de tensions de seuil distincte de celle des transistors du bloc 8. Dans ce cas, les transistors respectifs de ces blocs 6 et 8 sont aptes à être polarisés électriquement par des tensions différentes lors de leur fonctionnement. Pour simplifier, seuls trois éléments logiques 10, 12 et 14 sont représentés. De même, seuls deux éléments synchrones 16 et 18 sont représentés. Les éléments 10, 12 et 14 sont connectés entre eux de manière à former un ensemble 20, configuré pour accomplir une fonction logique prédéfinie. Cet ensemble 20 est configuré pour recevoir un signal d'entrée IN transmis depuis le bloc 6 et pour fournir un signal de sortie OUT en réponse au signal IN généré depuis le bloc 8. L'arbre d'horloge 4 est apte à transmettre un signal d'horloge CLK aux éléments 16 et 18 du circuit 2, de telle sorte que ce signal CLK soit reçu simultanément par ces éléments 16 et 18, pour synchroniser le fonctionnement de l'ensemble 20 avec le reste du circuit 2. Dans cet exemple, le signal CLK transmis par l'élément 16 est un signal périodique présentant une forme en créneaux.

Cet arbre d'horloge 4 est un réseau d'interconnexions électriques, présentant ici une forme en arborescence comprenant une pluralité de branches. Pour simplifier, seules deux branches 22 et 24 de cet arbre 4 sont représentées. Dans cet exemple, la branche 22 est reliée à une entrée d'horloge de l'élément 16, et la branche 24 est reliée à une entrée d'horloge de l'élément 18. Afin de limiter des différences de temps de propagation du signal CLK dans les branches 22 et 24 l'arbre 4 comprend une pluralité de cellules d'arbre d'horloge. Chacune de ces cellules d'horloge est ici configurée pour retarder la propagation du signal CLK avec un retard prédéfini. Ainsi, l'ajout sélectif de cellules d'arbre d'horloge dans des branches de l'arbre 4 permet de réduire ces différences de temps de propagation. Dans cet exemple, seules deux cellules d'arbre d'horloge 30, 32 sont représentées. Par exemple, ces cellules 30 et 32 sont des feuilles de l'arbre 4. Ces cellules 30 et 32 sont ici insérées, respectivement, au sein de chacun des blocs 6 et 8. Ces cellules 30 et 32 sont ici similaires, sauf que la cellule 30 est réalisée à l'intérieur du bloc 6 et que la cellule 32 est réalisée à l'intérieur du bloc 8.

Dans cette description, deux cellules similaires peuvent présenter des différences géométriques, par exemple rendues nécessaires par des étapes de conception du circuit, pour adapter ces cellules aux connexions électriques avec d'autres cellules du circuit, contiguës à ces cellules.

La figure 2 représente plus en détail le bloc 6 du circuit intégré 2. Ce circuit 2 comprend :
- un substrat semi-conducteur 34,
- une pluralité de rangées de cellules standards, et
- la cellule d'arbre d'horloge 30.

Le substrat 34 s'étend essentiellement dans un plan dit « plan du substrat ». Ici, le plan du substrat est parallèle à des directions horizontales orthogonales X et Y, et est perpendiculaire à une direction verticale Z. Ce plan du substrat forme une partie inférieure du circuit 2. Ce substrat 34 présente ici un dopage de type p avec une concentration de dopants inférieure ou égale à 10¹⁶ cm⁻³ ou à 3*10¹⁵ cm⁻³. Pour simplifier la figure 2, le substrat 34 est représenté sous la forme de traits pointillés. Ce substrat 34 est ici relié électriquement à une masse électrique GND du circuit 2.

Avantageusement, le circuit 2 comporte en outre un caisson (« well » en langue anglaise) profondément enterré 35. Ce caisson 35 s'étend continûment et parallèlement au plan du substrat 34. Ce caisson 35 est situé immédiatement sur le substrat 34. Ce caisson 35 permet de limiter l'apparition de courants de fuite vers le substrat 34. A cet effet, le type de dopage du caisson 35 est choisi notamment pour former une jonction p-n polarisée en sens inverse avec le substrat 34. Ici, le caisson 35 présente un dopage de type n. Pour simplifier la figure 2, le caisson 35 est représenté sous la forme de traits pointillés.

Les rangées présentent ici une forme sensiblement rectiligne et s'étendent, au sein du bloc 6, toutes suivant la direction X. Ces rangées présentent une même largeur, mesurée selon la direction Y. Ces rangées sont disposées les unes parallèles aux autres et sont contiguës deux à deux le long d'un de leurs côtés parallèle à la direction X.

Pour simplifier, seules les rangées 36 et 37 sont décrites. Les rangées 36 et 37 sont disposées au sein du bloc 6 parallèlement les unes aux autres et sont contiguës entre elles.

La rangée 36 comporte :
- des premier 38 et second 40 caissons semi-conducteurs, présentant des dopages de type opposé ;
- une pluralité de cellules standard,
- au moins une cellule de polarisation des caissons 38 et 40.

Dans cet exemple, le caisson 38 présente un dopage de type p. Le caisson 40 présente un dopage de type n. Les caissons 38 et 40 présentent une concentration de dopants comprise entre 10¹⁶ et 10¹⁸ cm⁻³.

Les caissons 38 et 40 sont disposés l'un à côté de l'autre dans un même plan, appelé « plan des caissons », parallèle au plan du substrat. Ces caissons 38 et 40 s'étendent chacun dans ce plan des caissons, parallèlement à la direction X. Ces caissons 38 et 40 sont ici situés au-dessus du caisson profond 35. Ainsi, le risque d'apparition de courants de fuite entre le caisson 38 et le substrat 34 est réduit.

Des cellules standard sont placées les unes à côté des autres dans la rangée 36, de sorte que les caissons 38 et 40 soient communs à toutes les cellules de la rangée 36. Ces cellules standard présentent ici chacune une forme sensiblement rectangulaire, avec une même hauteur que les rangées. Ces cellules standard sont séparées les unes des autres par des tranchées d'isolation 45 (« trench isolation » en langue anglaise). Pour simplifier, seules deux cellules standard 42 et 43, identiques et immédiatement adjacentes l'une à l'autre, sont représentées sur la figure 2. Sur le côté où les cellules 42 et 43 se touchent, la tranchée 45 est commune à ces cellules 42, 43.

La rangée 36 comprend ici une pluralité de cellules de polarisation des caissons 38 et 40. Ces cellules sont espacées régulièrement dans chaque rangée. Pour simplifier, seule une cellule de polarisation 44 est décrite en détail. La cellule 44 comprend des prises de contact 46, 48, respectivement reliées électriquement aux caissons 38 et 40. Ces prises 46 et 48 sont chacune aptes à polariser électriquement les caissons 38 et 40, lorsqu'une polarisation électrique est appliquée sur ladite prise par une source de tension. A cet effet, ces prises 46 et 48 sont en contact électrique direct avec, respectivement, les caissons 38 et 40. Ces prises 46 et 48 comprennent, par exemple, chacune une tranchée ménagée jusqu'aux caissons, respectivement, 38 et 40, et remplie d'un matériau électriquement conducteur, tel qu'un métal. Ainsi, les caissons respectifs de chaque rangée peuvent être polarisés à une valeur donnée de potentiel électrique.

Dans cette description, deux éléments sont dits être en contact direct s'ils sont immédiatement en contact physique l'un avec l'autre et si aucun autre élément de nature différente n'est interposé entre ces deux éléments.

Dans cet exemple, les rangées du bloc 6 sont placées dans une configuration dite retournée (« flipped rows» en langue anglaise) : les positions des caissons sont permutées d'une rangée sur l'autre, dans la direction Y, de telle sorte que deux caissons contigus l'un à l'autre et appartenant respectivement à deux rangées contiguës l'une à l'autre, présentent un même dopage. Ici, la rangée 37 est identique à la rangée 36, sauf que les positions des caissons sont permutées. Sur la figure 2, les caissons de cette rangée 37 correspondant aux caissons 38 et 40 portent, respectivement, les références numériques 39 et 41.

Avantageusement, le circuit 2 comporte :
- un réseau d'alimentation électrique 50, et
- une source d'alimentation électrique 52.

Le réseau 50 est apte à appliquer des polarisations électriques distinctes sur les caissons 38 et 40. Pour cela, ce réseau est ici relié électriquement aux prises 46 et 48. Dans cet exemple, le réseau est configuré pour que tous les caissons 38 et 39, 40 et 41 des rangées du bloc 6 présentant un même type de dopage soient polarisés à une même valeur de potentiel électrique.

La source 52 est apte à délivrer des tensions électriques sur le réseau 50.

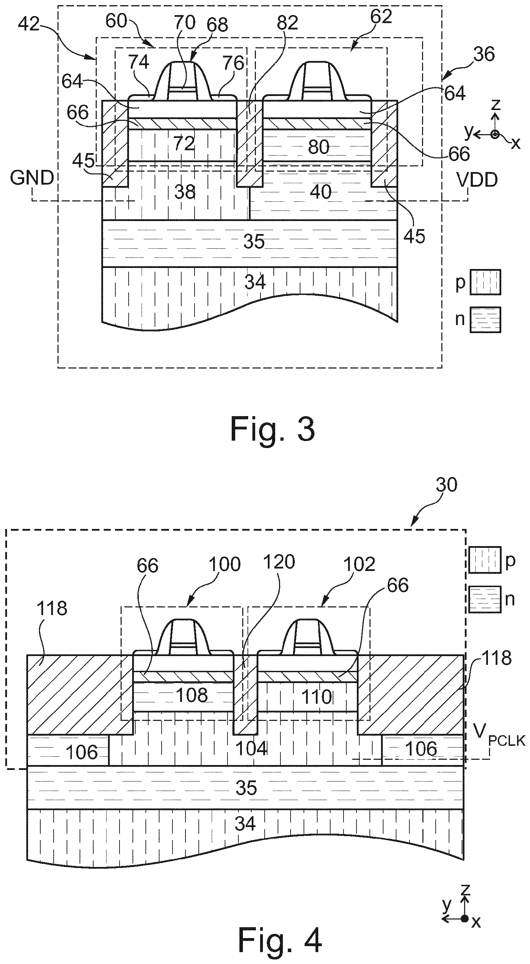

La figure 3 représente plus en détail une cellule 42 de la rangée 36. Typiquement, chaque cellule comprend ici deux transistors, le drain d'un de ces transistors étant directement connecté électriquement à la source de l'autre transistor de la même cellule. Dans la suite de cette description, pour simplifier les figures cette connexion électrique entre les deux transistors d'une même cellule n'a pas été représentée. La cellule 42 comprend des transistors 60, 62 à effet de champ et de type métal-oxyde-semi-conducteur (MOS). Ces transistors 60 et 62 sont réalisés suivant la technologie FDSOI. Les transistors 60 et 62 sont placés, respectivement, à l'aplomb des caissons 38 et 40.

Le transistor 60 comprend ainsi :
- une couche 64 semi-conductrice, dite couche active,
- une couche enterrée 66 de matériau électriquement isolant, située sous la couche 64,
- un empilement de grille 68, situé sur la couche 64 et comportant notamment une grille 70,
- un plan de masse semi-conducteur 72, situé sous la couche 66.

La couche 64 forme un canal entre une source 74 et un drain 76. De façon connue en technologie FDSOI, cette couche 64 est dans un état déserté (« depleted » en langue anglaise) et présente un niveau de dopage très faible, typiquement inférieur ou égal à 10¹⁵ cm⁻³. Cette couche 64 présente une épaisseur inférieure ou égale à 50nm.

Dans cette description, l'épaisseur et la profondeur sont définies par rapport à la direction Z. La profondeur est définie par rapport à un plan de référence horizontal, passant, par exemple, par la couche 66.

La couche 66 isole électriquement la couche 64 du plan de masse 72. Cette couche 66 s'étend sensiblement parallèlement au plan du substrat. La couche 66 est ici de type ultra-fine, dite UTBOX (pour « Ultra-Thin Buried OXide layer » en langue anglaise) et présente une épaisseur inférieure à 40nm et, de préférence, inférieure ou égale à 25nm. Par matériau électriquement isolant, on désigne ici un matériau dont la résistivité électrique, à une température de 20°C, est supérieure ou égale à 10⁵Ω.m ou à 10⁶Ω.m. Par exemple, cette couche 66 est ici réalisée en oxyde de silicium (SiO₂).

Le plan de masse 72 permet de contrôler des propriétés électrostatiques du transistor 60, en appliquant un potentiel électrique sur ce plan de masse 72. Le plan de masse 72 est situé directement et uniquement sur le caisson 38, de sorte que sa polarisation électrique puisse être appliquée par l'intermédiaire du caisson 38. A cet effet, le plan de masse 72 s'étend horizontalement et est disposé immédiatement au-dessus du caisson 38, de manière à être situé à l'aplomb de la couche 64.

Dans cet exemple, un plan de masse d'un transistor présente un même type de dopage que le caisson au-dessus duquel ce plan de masse est placé. Ici, le plan de masse 72 présente donc un dopage de même type que le dopage du caisson 38. La concentration de dopants du plan de masse 72 est ici comprise entre 10¹⁸ cm⁻³ et 10²⁰ cm⁻³. Ce plan de masse 72 présente ici une épaisseur comprise entre 50nm et 300nm et, de préférence, entre 70nm et 200nm. Le plan de masse 72 et le caisson 38 sont ici fabriqués à partir d'un même matériau semi-conducteur, par application d'étapes distinctes d'implantation ionique. Chacun du plan de masse 72 et du caisson 38 présente un profil de dopage distinct.

Dans cet exemple, le transistor 60 est un transistor de type n (nMOS). La source 74 et le drain 76 sont ici formés au-dessus de la couche 64. Ce transistor présente ici une tension de seuil intermédiaire, dite RVT (pour « Regular V_{T} » en langue anglaise).

Le transistor 62 est similaire au transistor 60, sauf qu'ici :
- le transistor 62 est de type p (pMOS), et
- le plan de masse 72 est remplacé par un plan de masse semi-conducteur 80, situé uniquement au-dessus et à l'aplomb du caisson 40 et présentant un dopage de même type que le dopage du caisson 40.

Par exemple, à l'exception des différences ci-dessus, tout ce qui a été décrit en référence au transistor 60 s'applique au transistor 62.

La cellule 42 comprend, en plus de la tranchée 45, une tranchée d'isolation 82, pour isoler électriquement les transistors 60, 62 les uns des autres. Par isolation des transistors 60 et 62, on entend ici que les plans de masse 72 et 80 sont notamment isolés électriquement l'un de l'autre. Plus spécifiquement, la tranchée 45 permet d'isoler électriquement les transistors 60, 62 des cellules standard adjacentes à la cellule 42. A cet effet, la tranchée 45 entoure, dans un plan horizontal, la cellule 42 sur tout son pourtour extérieur. La tranchée 82 permet d'isoler électriquement entre eux les transistors 60 et 62 d'une même cellule 42. Dans cet exemple, la tranchée 82 est située entre les transistors 60 et 62. Ces tranchées 45 et 82 s'étendent chacune, selon la direction Z, depuis une face supérieure de la couche 64 jusqu'à une extrémité inférieure, située dans le plan des caissons et présentant ici une même profondeur. Cette extrémité est ici située dans les caissons 38 et 40, à une profondeur supérieure à la profondeur des plans de masse 72 et 80. Ces tranchées 45 et 82 sont réalisées dans un matériau électriquement isolant. Par exemple, ces tranchées 45 et 82 sont réalisées en oxyde de silicium.

La cellule 30 (figure 2) est apte à recevoir un signal d'horloge entrant, et à transmettre un signal d'horloge sortant à une cellule 42 du bloc 6. Ici, le signal d'horloge entrant est le signal d'horloge CLK. Cette cellule 30 est entourée par des rangées, de sorte à être contiguë à des cellules standard. Ici, cette cellule 30 est disposée dans le prolongement de deux rangées du bloc 6. Cette cellule 30 est ici contiguë aux cellules 42 et 43 de la rangée 36.

La figure 4 représente plus en détail la cellule 30. Cette cellule 30 comporte :
- des transistors 100, 102 ;
- un seul caisson semi-conducteur 104, communs à tous les transistors de la cellule 30 ;
- une bande semi-conductrice 106 entourant, dans un plan horizontal, le caisson 104.

Les transistors 100 et 102 sont placés à l'aplomb du caisson 104. Ces transistors 100 et 102 sont aptes à être connectés pour former un dispositif optimisant la distribution du signal CLK par l'arbre 4. Ce dispositif est ici un délai (« buffer » en langue anglaise). Ces transistors 100 et 102 sont, par exemple, identiques aux transistors 60 et 62, sauf que les plans de masse 72 et 80 sont remplacés, respectivement, par des plans de masse 108 et 110. Ces plans de masse 108 et 110 présentent ici un même type de dopage, identique au dopage du caisson 104.

Le caisson 104 s'étend horizontalement. Ce caisson 104 est situé immédiatement en-dessous des plan de masse 108 et 110 et, ici, immédiatement au-dessus du caisson 35. Ce caisson 104 présente un dopage de même type que le dopage du caisson 38. Ici, ce dopage est donc de type p. La concentration de dopants du caisson 104 est, par exemple, sensiblement égale à la concentration de dopants du caisson 38. Ce caisson 104 s'étend jusqu'à une même profondeur que les caissons 38 et 40, à 10 % ou à 5 % près. Ainsi, ce caisson 104 s'étend dans le plan des caissons 38 à 41.

La bande 106 est interposée entre le caisson 104 et les caissons 38 et 40 des cellules 42 contiguës à la cellule 30. Cette bande 106 permet notamment de séparer et d'isoler électriquement le caisson 104 des caissons 38 et 39 des rangées immédiatement adjacentes. A cet effet, cette bande 106 présente un dopage de type opposé au type de dopage du caisson 104, de manière à former une jonction p-n polarisée en inverse avec les caissons 104, 38 et 39.

Cette bande 106 présente une largeur telle que la plus petite distance séparant les caissons 104 et 38 soit supérieure ou égale à une valeur seuil L₁, comme illustré sur la figure 2 par les flèches 112 et 114. Cette distance est ici mesurée selon une direction horizontale. La valeur seuil dépend, notamment, de contraintes imposées par des règles de dessin spécifiques au noeud technologique du procédé de fabrication du circuit 2. Ces règles imposent notamment ici une valeur seuil de distance à respecter entre deux caissons présentant un dopage de type p. Dans cet exemple, pour une technologie 28nm, la valeur seuil est supérieure ou égale à 1µm ou à 500nm ou à 100nm .

Ici, la bande 106 est une couche semi-conductrice présentant un dopage de type n, avec une concentration de dopage sensiblement égale à celle du caisson 104. Cette bande 106 s'étend parallèlement au plan du substrat 34 en entourant continûment le caisson 104. Cette bande 106 présente une même profondeur que le caisson 104. Cette bande 106 est ici contiguë, notamment, au caisson 40 et est apte à être portée à un même potentiel électrique que le caisson 40.

Ainsi la bande 106 permet d'isoler électriquement le caisson 104, tout en respectant la valeur L₁ imposée par les règles de dessin, sans consommer une superficie excessive du circuit 2. La cellule d'arbre d'horloge 30 peut donc être intégrée au plus près des cellules 42, en occupant une superficie réduite, tout en étant protégée contre des interférences électriques provenant des cellules 42.

Dans cet exemple, le réseau 50 est en outre configuré pour permettre l'application, sur le caisson 104, d'une polarisation électrique distincte de la polarisation électrique appliquée aux caissons 38 et/ou 40.

Avantageusement, la cellule 30 comporte une prise 116 (figure 2) pour polariser électriquement le caisson 104. Cette prise 116 est, par exemple, identique aux prises 46 et 48 et donc est directement électriquement reliée au caisson 104.

Les plans de masse 108 et 110 peuvent ainsi être polarisés électriquement, par l'intermédiaire du caisson 104 et indépendamment de la polarisation appliquée aux caissons 38 et 40. Cette polarisation des plans de masse 108 et 110 permet de contrôler des propriétés électrostatiques des transistors 100 et 102. Ce contrôle permet notamment de compenser dynamiquement une asymétrie entre des propriétés électriques des transistors 100 et 102.

En effet, les transistors 100 et 102 de la cellule 30 forment ici un élément logique de type CMOS (« Complementary Metal Oxide Semiconductor » en langue anglaise). Les transistors 100 et 102 présentent un rapport de symétrie (« beta ratio » en langue anglaise) choisi ici de façon à ce que les temps de montée et de descente (« rise time » et « fall time » en langue anglaise) du signal d'horloge sortant, transmis par cette cellule 30, soient sensiblement égaux.

Une modification de ce rapport de symétrie, dite asymétrie, entre des transistors d'une même cellule d'arbre d'horloge peut affecter défavorablement le comportement de l'arbre 4. Cette asymétrie peut dépendre de paramètres non contrôlables et/ou non prévisibles, tels que de l'environnement de fonctionnement du circuit 2 (par exemple la température), ou des variabilités aléatoires dans le processus de fabrication du circuit 2.

Ici, la cellule 30 comprend également des tranchées d'isolation 118 et 120. Les tranchées 118 et 120 présentent, respectivement, des fonctions similaires à celles des tranchées 45 et 82 de la cellule 42. La tranchée 120 est par exemple identique à la tranchée 82. La tranchée 118 est réalisée comme la tranchée 45 mais peut présenter une largeur plus importante dans la direction Y. Dans cet exemple, la tranchée 118 ne forme qu'un seul bloc de matière avec la tranchée 45 des cellules 42, 43 qui sont immédiatement contiguës à cette cellule 30, sur les côtés où la cellule 30 est contiguë à ces cellules 42, 43.

Avantageusement, la cellule 30 comprend des composants électriques passifs, tels qu'une diode d'antenne 124 ou un condensateur de découplage 126 (figure 2), situés au-dessus de la couche 66 et à l'aplomb de la bande 106. Ces composants peuvent être électriquement reliés à d'autres éléments du circuit 2 ou de la cellule 30.

Les circuits intégrés comprennent de tels composants électriques passifs 124, 126. Ici, la portion de la cellule 30 située à l'aplomb du caisson 106 présente une superficie importante, sur laquelle il n'est pas souhaitable de placer un transistor. Ainsi, cette superficie est réutilisée pour placer les éléments 124, 126. En plaçant les éléments 124, 126 sur cette superficie, il est possible de libérer de l'espace dans une autre zone du circuit 2.

Dans cet exemple, la diode 124 protège la cellule 30 contre des effets d'antenne pouvant survenir lors d'étapes de fabrication du circuit 2. A cet effet, la diode 124 est électriquement connectée entre une portion du réseau d'interconnexion formant l'arbre 4 et un potentiel électrique de référence, pour limiter le risque que des charges électriques accumulées dans cette portion du réseau d'interconnexion lors de la fabrication de ce réseau ne dégradent des propriétés électriques de la cellule 30. Ce potentiel de référence est, par exemple, la masse GND. Pour simplifier la figure 2, cette connexion n'est pas représentée. Cette diode 124 est, par exemple, une diode p-n formée au-dessus de la couche 66.

Le condensateur 126 est ici connecté électriquement entre l'un ou l'autre des transistors 100 ou 102 et le potentiel électrique de référence, pour protéger ce transistor 100 ou 102 contre des perturbations électriques pouvant survenir pendant le fonctionnement du circuit 2.

Par exemple, le condensateur 126 comprend un condensateur de type métal-isolant-métal (MIM) formé dans des niveaux dits « métal » du circuit 2, lors d'étapes de réalisation d'interconnexions électriques du circuit 2 (« interconnect layers » en langue anglaise).

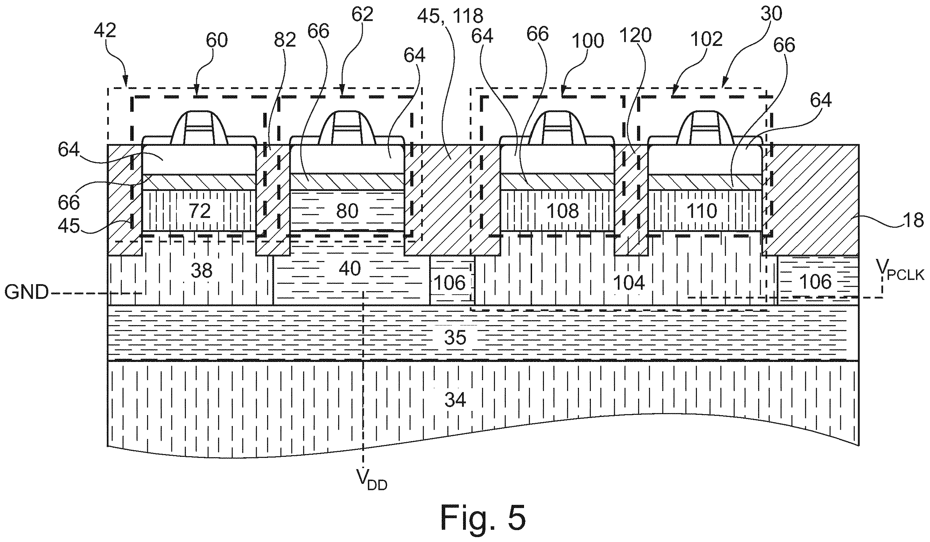

La figure 5 illustre un bloc 140, apte à être utilisé à la place du bloc 6. Ce bloc est identique au bloc 6, sauf que les rangées sont disposées dans une configuration dite non retournée (« regular » en langue anglaise). A cet effet, la rangée 37 est remplacée par une rangée 142. Cette rangée 142 est, par exemple, identique à la rangée 37, sauf que les positions des caissons 39 et 41 sont permutées.

Avec cette disposition des caissons, le caisson 104 et la bande 106 sont dimensionnés de telle sorte à respecter la contrainte de distance imposée par les règles de dessin, comme illustré par la flèche 144. Par exemple, la contrainte de distance est la même que celle pour le bloc 6.

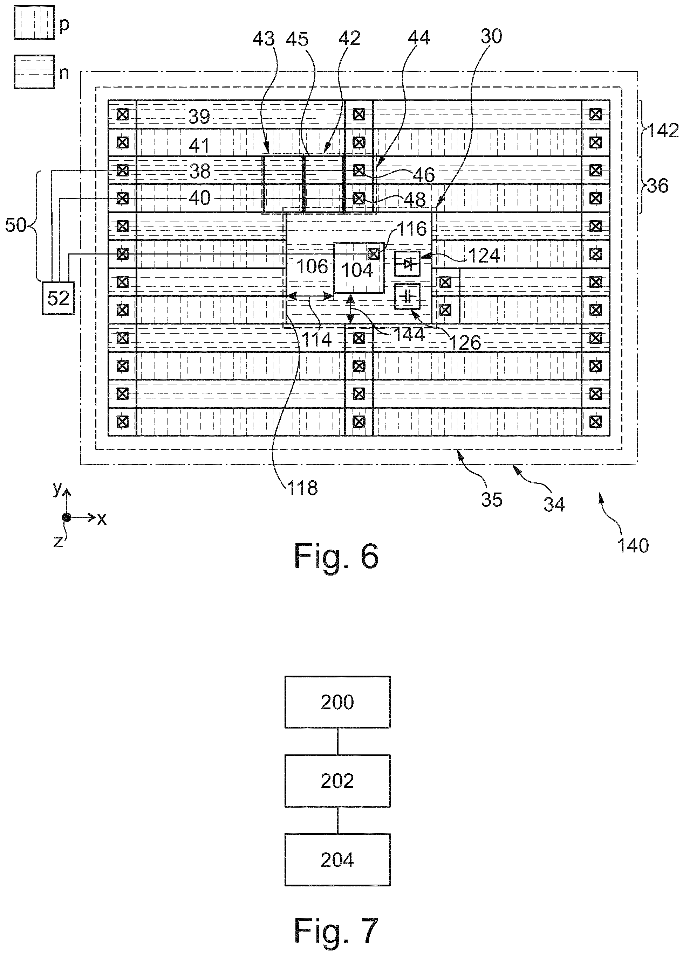

Un exemple de fonctionnement du circuit intégré 2 va maintenant être décrit en référence au procédé de la figure 6 et à l'aide des figures 2 et 3.

Lors d'une étape 200, le circuit 2 est, par exemple, mis en marche et alimenté par une source de tension électrique.

Lors d'une étape 202, des polarisations V_{PW} et V_{NW} sont appliquées, respectivement, sur les caissons 38 et 40.

Ces polarisations V_{PW} et V_{NW} sont ici appliquées par le réseau 50. Ces polarisations V_{PW} et V_{NW} sont ici, respectivement, égales à la masse GND et à une tension VDD d'alimentation du circuit.

Lors d'une étape 204, une polarisation V_{PCLK} est appliquée sur le caisson 104. Cette polarisation V_{PCLK} est inférieure ou égale à la plus petite valeur de polarisation V_{NW} appliquée au même moment sur le caisson 40, de façon à limiter le risque de polariser en sens direct la jonction p-n formée par le contact entre le caisson 104 et la bande 106 (la bande 106 étant au même potentiel électrique que le caisson 40). Ici, la tension V_{PCLK} est égale à la masse GND.

De nombreux autres modes de réalisation sont possibles.

En variante, le caisson profond 35 est omis. Dans ce cas, les caissons 38, 39, 40, 41 et 104 et la bande 106 sont en contact direct avec le substrat 34. Afin de limiter l'apparition de courants de fuite entre les caissons 38, 39, 104 d'une part et 40, 41 et la bande 106 d'autre part, via le substrat 34, les polarisations V_{PW} et V_{NW} sont adaptées pour éviter que ces caissons 40, 41 et cette bande 106 ne forment avec le substrat 34 des jonctions p-n polarisées en sens direct. Pour ce faire, le réseau 50 est configuré pour que la polarisation V_{PW} soit égale à la masse GND.

La cellule 30 peut présenter une autre fonction que celle de délai. La cellule 30 est, par exemple, adaptée pour contrôler la propagation du signal d'horloge entrant à l'aide d'un autre signal de contrôle (« gated clock » en langue anglaise).

Les transistors 60, 62 du bloc 6 peuvent présenter une autre tension de seuil. Par exemple, ces transistors peuvent présenter une tension de seuil de type élevée (HVT) ou faible (LVT). Dans ce cas, les polarisations V_{PW} et V_{NW} peuvent prendre une valeur différente de celle décrite.

En variante, la source 74 et le drain 76 ne sont pas formés sur la couche 64, mais sont formés à l'intérieur de cette couche 64.

Le circuit 2 illustré à la figure 1 peut être différent de l'exemple illustré, et peut notamment comporter un plus grand nombre d'éléments logiques et/ou synchrones. L'ensemble 20 peut comprendre plus d'une entrée IN et/ou plus d'une sortie OUT.

La cellule 42 peut comprendre plus de deux transistors 60 et 62.

En variante, la prise 46 du caisson 38 est omise, dans le cas où les caissons 38 et 39 présentant un même type de dopage sont contigus et que le caisson 39 comporte déjà une prise identique à la prise 46. Il en va de même pour la prise 48 et le caisson 40.

Le condensateur 126 peut être formé dans la couche semi-conductrice située au-dessus de la couche 66, par exemple au moyen d'une jonction p-n polarisée en inverse ou d'un transistor MOS.

La source 52 peut être omise. Dans ce cas, le réseau 50 est électriquement relié à une source d'alimentation située hors du circuit 2.

Les polarisations V_{NW} et V_{PW} peuvent varier au cours du temps. Ces polarisations V_{NW} et V_{PW} peuvent être modulées par une valeur variable ΔV, par exemple pour appliquer des polarisations de type inverse ou direct (respectivement dites RBB et FBB, pour « reverse back-biasing » et « forward back-biasing » en langue anglaise). Il en va de même pour la polarisation V_{PCLK}. Ces polarisations V_{NW}, V_{PW} et V_{PCLK} peuvent être appliquées dans un ordre différent de celui décrit.

Le substrat 34 peut présenter un dopage de type n. Dans ce cas, le dopage du caisson 35 est de type n.

Les éléments 124 et 126 peuvent être omis.

## Revendications

1. Circuit intégré (2), comprenant :
- un substrat semi-conducteur (34) de type silicium-sur-isolant (SOI), s'étendant essentiellement dans un plan, dit plan du substrat,
- un bloc (6) disposé sur le substrat et comportant :
• au moins un premier (38) et un second (40) caissons semi-conducteurs de dopages opposés, disposés l'un à côté de l'autre dans un même plan des caissons parallèle au plan du substrat ;
• des cellules standard (42, 43), contiguës entre elles, chaque cellule standard (42) comportant des premiers transistors (60, 62) à effet de champ de technologie FDSOI, chaque premier transistor (60, 62) comprenant un premier plan de masse (72, 80) semi-conducteur, uniquement disposé au-dessus d'un seul des premier ou second caissons, pour être électriquement polarisé par l'intermédiaire du caisson (38, 40) au-dessus duquel il est disposé ;
• une cellule d'arbre d'horloge (30), entourée par les cellules standard, de sorte que la cellule d'arbre d'horloge soit contiguë à des cellules standard (42, 43), la cellule d'arbre d'horloge (30) comportant :
- un troisième caisson semi-conducteur (104), s'étendant dans le plan des caissons, le troisième caisson présentant un dopage de même type que le dopage du premier caisson (38) ;
- des seconds transistors (100, 102) à effet de champ de technologie FDSOI, chaque second transistor comportant un second plan de masse semi-conducteur (108, 110), chaque plan de masse de chaque second transistor de la cellule d'arbre d'horloge étant situé au-dessus du troisième caisson (104), pour être électriquement polarisé par l'intermédiaire de ce troisième caisson ;
- une bande semi-conductrice (106), s'étendant continûment autour du troisième caisson (104), dans le plan des caissons, la bande semi-conductrice présentant un dopage de type opposé au dopage du troisième caisson, de manière à isoler électriquement le troisième caisson (104) du premier caisson (38).

2. Circuit intégré selon la revendication 1, dans lequel :
- chaque premier caisson (38) présente un dopage de même type que le dopage du substrat (34) ;
- le bloc comprend en outre un caisson profondément enterré (35), s'étendant continûment, dans un plan parallèle au plan du substrat et situé sous le plan des caissons, sous chaque premier caisson du bloc et sous le troisième caisson, le caisson profondément enterré présentant un dopage de type opposé à celui du substrat pour isoler électriquement du substrat (34) chaque premier caisson (38, 39) et le troisième caisson (104).

3. Circuit intégré selon l'une quelconque des revendications précédentes, dans lequel le circuit comprend un réseau d'interconnexions électriques, le réseau comprenant des liaisons électriques aptes :
• à transmettre, vers des seules cellules d'arbre d'horloge d'un même arbre d'horloge (4), au moins un signal d'horloge entrant, à partir duquel chaque cellule d'arbre d'horloge est apte à générer au moins un signal d'horloge sortant, et
• à transmettre le signal d'horloge sortant de la cellule d'arbre d'horloge vers des cellules standard ou d'autres cellules d'horloge situées dans le même bloc.

4. Circuit intégré selon l'une quelconque des revendications précédentes, dans lequel le circuit comporte un réseau d'alimentation électrique (50), le réseau d'alimentation comprenant des première et seconde liaisons électriques, isolées électriquement l'une de l'autre, la première liaison électrique permettant l'application d'une première polarisation électrique sur le premier caisson (38) et la seconde liaison permettant l'application d'une seconde polarisation électrique sur le troisième caisson (104).

5. Circuit intégré selon l'une quelconque des revendications précédentes, dans laquelle le bloc comporte, pour chaque premier (38) et second (40) caissons, au moins une première prise (46, 48) par caisson directement en contact électrique avec ce caisson, cette première prise étant apte à être électriquement reliée à une source de tension extérieure.

6. Circuit intégré selon l'une quelconque des revendications précédentes, dans lequel la cellule d'arbre d'horloge (30) comprend au moins une prise (116) directement en contact électrique avec le troisième caisson (104), cette prise étant apte à polariser électriquement ce troisième caisson par une polarisation électrique fournie par une source de tension extérieure.

7. Circuit intégré selon l'une quelconque des revendications précédentes, dans lequel la cellule d'arbre d'horloge (30) comprend une diode dite d'antenne (124) directement électriquement reliée entre une portion d'un réseau d'interconnexion et un potentiel électrique de référence et apte à protéger électriquement la cellule d'arbre d'horloge (30) contre des effets d'antenne pouvant survenir lors d'étapes de fabrication du circuit, cette diode étant à cet effet située au-dessus de la bande semi-conductrice (106), dans une direction perpendiculaire au plan du substrat et du côté opposé au substrat.

8. Circuit intégré selon l'une quelconque des revendications précédentes, dans lequel la cellule d'arbre d'horloge (30) comprend un condensateur de découplage (126) apte à protéger électriquement un réseau d'alimentation électrique contre des perturbations électriques, ce condensateur de découplage étant à cet effet directement relié électriquement entre un réseau d'alimentation électrique (50) et un potentiel électrique de référence, le condensateur de découplage étant situé au-dessus de la bande semi-conductrice (106), dans une direction perpendiculaire au plan du substrat et du côté opposé au substrat.

9. Circuit intégré selon l'une quelconque des revendications précédentes, dans lequel la plus petite distance (112, 114) séparant le troisième caisson (104) d'un premier caisson est supérieure ou égale à 100nm.

10. Circuit intégré selon l'une quelconque des revendications précédentes, dans laquelle :
- la cellule d'arbre d'horloge (30) comporte une première tranchée d'isolation (118), en matériau électriquement isolant, entourant chaque plan de masse de chaque transistor de la cellule d'arbre d'horloge, pour séparer le plan de masse de chaque transistor de la cellule d'arbre d'horloge des plans de masse des transistors des cellules standard contiguës, et
- chaque cellule standard (42) comprend une seconde tranchée d'isolation (45), en matériau électriquement isolant, entourant chaque plan de masse de chaque transistor de la cellule standard, pour séparer le plan de masse de chaque transistor de cette cellule standard des plans de masse des transistors des cellules standard contiguës, une partie de cette seconde tranchée d'isolation étant commune à la première tranchée d'isolation si cette cellule standard est immédiatement contiguë à la cellule d'arbre d'horloge.

11. Circuit intégré selon l'une quelconque des revendications précédentes, dans lequel les cellules du bloc sont agencées en rangées (36, 37) de cellules parallèles et contiguës entre elles, chaque rangée comportant uniquement un exemplaire du premier et du second caissons, ces premier et second caissons d'une même rangée s'étendant dans le plan des caissons parallèlement à la rangée.

12. Procédé d'utilisation d'un circuit intégré, comprenant les étapes suivantes :
- la fourniture (200) d'un circuit intégré conforme à l'une quelconque des revendications précédentes ;
- l'application (202) de première et seconde polarisations électriques sur, respectivement, les premier et second caissons du circuit ;
- l'application (204) d'une troisième polarisation électrique sur le troisième caisson du circuit, cette troisième polarisation étant choisie en fonction des première et seconde polarisations appliquées au même moment sur les premier et second caissons pour que la jonction p-n formée par le troisième caisson et la bande semi-conductrice soit électriquement polarisée en sens inverse.

## Patentansprüche

1. Integrierter Schaltkreis (2), welcher umfasst:
- ein Halbleitersubstrat (34) vom Typ "Silizium auf Isolator" (SOI), das sich im Wesentlichen in einer Ebene, Substratebene genannt, erstreckt,
- einen Block (6), der auf dem Substrat angeordnet ist und aufweist:
• wenigstens eine erste (38) und eine zweite (40) Halbleiterwanne mit entgegengesetzten Dotierungen, die nebeneinander in ein und derselben, zur Ebene des Substrats parallelen Ebene der Wannen angeordnet sind,
• Standardzellen (42, 43), die aneinander angrenzen, wobei jede Standardzelle (42) erste mit FD-SOI-Technologie hergestellte Feldeffekttransistoren (60, 62) aufweist, wobei jeder erste Transistor (60, 62) eine erste halbleitende Masseebene (72, 80) umfasst, die ausschließlich über nur einer von der ersten und zweiten Wanne angeordnet ist, um über die Wanne (38, 40), über welcher er angeordnet ist, elektrisch vorgespannt zu werden;
• eine Taktbaumzelle (30), die von Standardzellen umgeben ist, derart, dass die Taktbaumzelle an Standardzellen (42, 43) angrenzt, wobei die Taktbaumzelle (30) aufweist:
- eine dritte Halbleiterwanne (104), die sich in der Ebene der Wannen erstreckt, wobei die dritte Wanne eine Dotierung von demselben Typ wie die Dotierung der ersten Wanne (38) aufweist;
- zweite mit FD-SOI-Technologie hergestellte Feldeffekttransistoren (100, 102), wobei jeder zweite Transistor eine zweite halbleitende Masseebene (108, 110) aufweist, wobei sich jede Masseebene jedes zweiten Transistors der Taktbaumzelle über der dritten Wanne (104) befindet, um über diese dritte Wanne elektrisch vorgespannt zu werden;
- ein halbleitendes Band (106), das sich in der Ebene der Wannen durchgehend um die dritte Wanne (104) herum erstreckt, wobei das halbleitende Band eine Dotierung von einem Typ aufweist, der zur Dotierung der dritten Wanne entgegengesetzt ist, um so die dritte Wanne (104) elektrisch von der ersten Wanne (38) zu isolieren.

2. Integrierter Schaltkreis nach Anspruch 1, wobei:
- jede erste Wanne (38) eine Dotierung von demselben Typ wie die Dotierung des Substrats (34) aufweist;
- der Block außerdem eine tief vergrabene Wanne (35) umfasst, die sich durchgehend in einer Ebene, die zur Ebene des Substrats parallel ist und sich unter der Ebene der Wannen befindet, unter jeder ersten Wanne des Blocks und unter der dritten Wanne erstreckt, wobei die tief vergrabene Wanne eine Dotierung von einem Typ aufweist, der zu demjenigen des Substrats entgegengesetzt ist, um jede erste Wanne (38, 39) und die dritte Wanne (104) elektrisch vom Substrat (34) zu isolieren.

3. Integrierter Schaltkreis nach einem der vorhergehenden Ansprüche, wobei der Schaltkreis ein Netz von elektrischen Zwischenverbindungen umfasst, wobei das Netz elektrische Verbindungen umfasst, welche geeignet sind:
• allein zu Taktbaumzellen ein und desselben Taktbaumes (4) wenigstens ein eingehendes Taktsignal zu übertragen, aus welchem jede Taktbaumzelle in der Lage ist, wenigstens ein ausgehendes Taktsignal zu erzeugen, und
• das ausgehende Taktsignal der Taktbaumzelle zu Standardzellen oder anderen Taktzellen, die sich in demselben Block befinden, zu übertragen.

4. Integrierter Schaltkreis nach einem der vorhergehenden Ansprüche, wobei der Schaltkreis ein Stromversorgungsnetz (50) aufweist, wobei das Versorgungsnetz eine erste und eine zweite elektrische Verbindung umfasst, die elektrisch voneinander isoliert sind, wobei die erste elektrische Verbindung das Anlegen einer ersten elektrischen Vorspannung an die erste Wanne (38) ermöglicht und die zweite Verbindung das Anlegen einer zweiten elektrischen Vorspannung an die dritte Wanne (104) ermöglicht.

5. Integrierter Schaltkreis nach einem der vorhergehenden Ansprüche, wobei der Block für jede erste (38) und zweite (40) Wanne wenigstens einen ersten Abgriff (46, 48) pro Wanne aufweist, der sich direkt in elektrischem Kontakt mit dieser Wanne befindet, wobei dieser erste Abgriff geeignet ist, elektrisch mit einer äußeren Spannungsquelle verbunden zu werden.

6. Integrierter Schaltkreis nach einem der vorhergehenden Ansprüche, wobei die Taktbaumzelle (30) wenigstens einen Abgriff (116) umfasst, der sich direkt in elektrischem Kontakt mit der dritten Wanne (104) befindet, wobei dieser Abgriff geeignet ist, diese dritte Wanne durch eine elektrische Vorspannung, die von einer äußeren Spannungsquelle geliefert wird, elektrisch vorzuspannen.

7. Integrierter Schaltkreis nach einem der vorhergehenden Ansprüche, wobei die Taktbaumzelle (30) eine Diode, Antennendiode (124) genannt, umfasst, die direkt elektrisch zwischen einen Abschnitt eines Zwischenverbindungsnetzes und ein elektrisches Bezugspotential geschaltet ist und geeignet ist, die Taktbaumzelle (30) vor Antenneneffekten, die in Fertigungsschritten des Schaltkreises auftreten können, elektrisch zu schützen, wobei sich diese Diode zu diesem Zweck über dem halbleitenden Band (106) befindet, in einer zur Ebene des Substrats senkrechten Richtung und auf der zum Substrat entgegengesetzten Seite.

8. Integrierter Schaltkreis nach einem der vorhergehenden Ansprüche, wobei die Taktbaumzelle (30) einen Entkopplungskondensator (126) umfasst, der geeignet ist, ein Stromversorgungsnetz elektrisch vor elektrischen Störungen zu schützen, wobei dieser Entkopplungskondensator zu diesem Zweck direkt elektrisch zwischen ein Stromversorgungsnetz (50) und ein elektrisches Bezugspotential geschaltet ist, wobei sich der Entkopplungskondensator über dem halbleitenden Band (106) befindet, in einer zur Ebene des Substrats senkrechten Richtung und auf der zum Substrat entgegengesetzten Seite.

9. Integrierter Schaltkreis nach einem der vorhergehenden Ansprüche, wobei der kleinste Abstand (112, 114), der die dritte Wanne (104) von einer ersten Wanne trennt, größer oder gleich 100 nm ist.

10. Integrierter Schaltkreis nach einem der vorhergehenden Ansprüche, wobei:
- die Taktbaumzelle (30) einen ersten Isolationsgraben (118) aus elektrisch isolierendem Material aufweist, der jede Masseebene jedes Transistors der Taktbaumzelle umgibt, um die Masseebene jedes Transistors der Taktbaumzelle von den Masseebenen der Transistoren der angrenzenden Standardzellen zu trennen, und
- jede Standardzelle (42) einen zweiten Isolationsgraben (45) aus elektrisch isolierendem Material umfasst, der jede Masseebene jedes Transistors der Standardzelle umgibt, um die Masseebene jedes Transistors dieser Standardzelle von den Masseebenen der Transistoren der angrenzenden Standardzellen zu trennen, wobei ein Teil dieses zweiten Isolationsgrabens gleichzeitig Teil des ersten Isolationsgrabens ist, falls diese Standardzelle unmittelbar an die Taktbaumzelle angrenzt.

11. Integrierter Schaltkreis nach einem der vorhergehenden Ansprüche, wobei die Zellen des Blocks in Reihen (36, 37) von parallelen und aneinander angrenzenden Zellen angeordnet sind, wobei jede Reihe nur ein Exemplar der ersten und der zweiten Wanne aufweist, wobei sich diese erste und zweite Wanne ein und derselben Reihe in der Ebene der Wannen parallel zu der Reihe erstrecken.

12. Verfahren zur Verwendung eines integrierten Schaltkreises, welches die folgenden Schritte umfasst:
- Bereitstellung (200) eines integrierten Schaltkreises gemäß einem der vorhergehenden Ansprüche;
- Anlegen (202) einer ersten und einer zweiten elektrischen Vorspannung an die erste bzw. zweite Wanne des Schaltkreises;
- Anlegen (204) einer dritten elektrischen Vorspannung an die dritte Wanne des Schaltkreises, wobei diese dritte Vorspannung in Abhängigkeit von der ersten und zweiten Vorspannung gewählt wird, die zu demselben Zeitpunkt an die erste und zweite Wanne angelegt werden, damit der p-n-Übergang, der von der dritten Wanne und dem halbleitenden Band gebildet wird, in umgekehrter Richtung elektrisch vorgespannt wird.

## Claims

1. Integrated circuit (2), comprising:
- a semiconductor substrate (34) of silicon-on-insulator (SOI) type lying essentially in a plane called the substrate plane;
- a block (6) located on the substrate comprising:
• at least first (38) and second (40) oppositely doped semiconductor wells, placed beside each other in a given well plane parallel to the substrate plane;
• contiguous standard cells (42, 43), each standard cell (42) comprising first field-effect transistors (60, 62) in FDSOI technology, each first transistor (60, 62) comprising a first semiconductor ground plane (72, 80) located only above a single of the first or second wells, in order to be electrically biased by way of the well (38, 40) above which it is located; and
• a clock tree cell (30) encircled by standard cells, so that the clock tree cell is contiguous with standard cells (42, 43), the clock tree cell (30) comprising:
- a third semiconductor well (104), lying in the well plane, the third well having the same doping type as the doping of the first well (38);
- second field-effect transistors (100, 102) in FDSOI technology, each second transistor comprising a second semiconductor ground plane (108, 110), each ground plane of each second transistor of the clock tree cell being located above the third well (104), in order to be electrically biased by way of this third well; and
- a semiconductor strip (106) extending continuously around the third well (104), in the well plane, the semiconductor strip having the opposite doping type to the doping of the third well, so as to electrically isolate the third well (104) from the first well (38).

2. Integrated circuit according to Claim 1, in which:
- each first well (38) has the same doping type as the doping of the substrate (34); and
- the block furthermore comprises a deep buried well (35), extending continuously, in a plane parallel to the substrate plane located under the well plane, under each first well of the block and under the third well, the deep buried well having the opposite doping type to that of the substrate in order to electrically isolate from the substrate (34) each first well (38, 39) and the third well (104).

3. Integrated circuit according to either one of the preceding claims, in which the circuit comprises an electrical interconnect network, the network comprising electrical connections able to:
• transmit, only to clock tree cells of a given clock tree (4), at least one input clock signal, from which each clock tree cell is able to generate at least one output clock signal; and
• transmit the output clock signal of the clock tree cell to standard cells or other clock cells located in the same block.

4. Integrated circuit according to any one of the preceding claims, in which the circuit comprises an electrical power supply network (50), the power supply network comprising first and second electrical connections that are electrically isolated from each other, the first electrical connection allowing a first electrical bias to be applied to the first well (38) and the second connection allowing a second electrical bias to be applied to the third well (104).

5. Integrated circuit according to any one of the preceding claims, in which the block comprises, for each of the first (38) and second (40) wells, at least one first connector (46, 48) per well making direct electrical contact with this well, this first connector being able to be electrically connected to an external voltage source.

6. Integrated circuit according to any one of the preceding claims, in which the clock tree cell (30) comprises at least one connector (116) making direct electrical contact with the third well (104), this connector being able to electrically bias this third well with an electrical bias delivered by an external voltage source.

7. Integrated circuit according to any one of the preceding claims, in which the clock tree cell (30) comprises an antenna diode (124) electrically connected directly between a portion of an interconnect network and an electrical reference potential and able to protect electrically the clock tree cell (30) from antenna effects that could be encountered in steps for fabricating the circuit, this diode being, for this purpose, located above the semiconductor strip (106), in a direction perpendicular to the substrate plane and on the side opposite the substrate.

8. Integrated circuit according to any one of the preceding claims, in which the clock tree cell (30) comprises a decoupling capacitor (126) able to protect electrically an electrical power supply network from electrical interference, this decoupling capacitor being, for this purpose, electrically connected directly between an electrical power supply network (50) and an electrical reference potential, the decoupling capacitor being located above the semiconductor strip (106), in a direction perpendicular to the plane of the substrate and on the side opposite the substrate.

9. Integrated circuit according to any one of the preceding claims, in which the smallest distance (112, 114) separating the third well (104) and a first well is 100 nm or more.

10. Integrated circuit according to any one of the preceding claims, in which:
- the clock tree cell (30) comprises a first trench isolation (118), made of an electrically insulating material, encircling each ground plane of each transistor of the clock tree cell, in order to separate the ground plane of each transistor of the clock tree cell from the ground planes of the transistors of contiguous standard cells; and
- each standard cell (42) comprises a second trench isolation (45) made of an electrically insulating material, encircling each ground plane of each transistor of the standard cell, in order to separate the ground plane of each transistor of this standard cell from the ground planes of the transistors of contiguous standard cells, a portion of this second trench isolation being common to the first trench isolation if this standard cell is immediately contiguous with the clock tree cell.

11. Integrated circuit according to any one of the preceding claims, in which the cells of the block are arranged in rows (36, 37) of cells parallel to and contiguous with one another, each row only comprising one example of the first and second well, these first and second wells of a given row extending, in the well plane, parallel to the row.

12. Method for using an integrated circuit, comprising the following steps:
- providing (200) an integrated circuit according to any one of the preceding claims;
- applying (202) first and second electrical biases to the first and second wells of the circuit, respectively; and
- applying (204) a third electrical bias to the third well of the circuit, this third bias being chosen depending on the first and second biases applied, at the same time, to the first and second wells, so that the p-n junction formed by the third well and the semiconductor strip is reverse biased.
